# EUROPEAN PATENT SPECIFICATION

(11) **EP 4 528 299 B1**
(45) Date of publication and mention of the grant of the patent: **08.04.2026**
(21) Application number: 24201008.0
(22) Date of filing: 18.09.2024
(51) Int. Cl.: G01R 33/34, G01R 33/3415

(54) **RECEPTION COIL DEVICE AND MAGNETIC RESONANCE IMAGING APPARATUS**
EMPFANGSSPULE UND VORRICHTUNG FÜR DIE MAGNETRESONANZBILDGEBUNG
DISPOSITIF DE BOBINE DE RÉCEPTION ET APPAREIL D'IMAGERIE PAR RÉSONANCE MAGNÉTIQUE

(30) Priority: 21.09.2023 JP 2023155715
(43) Date of publication of application: 26.03.2025
(73) Proprietor: FUJIFILM Corporation, Tokyo 106-8620 (JP)
(72) Inventor: NAKAYAMA, Takeshi, Kashiwa-shi, Chiba 277-0804 (JP); KATO, Kazuyuki, Kashiwa-shi, Chiba 277-0804 (JP)
(74) Representative: Strehl & Partner mbB

(56) References cited:
- CN-U- 207 366 722
- US-A- 5 617 027
- US-A1- 2009 012 389
- US-A1- 2014 021 949
- US-A1- 2017 299 669
- US-A1- 2022 087 563

## Description

### BACKGROUND OF THE INVENTION

### 1. Field of the Invention

The present invention relates to a reception coil device and a magnetic resonance imaging apparatus, and particularly, to a technology of automatically setting a reception coil to an examination part of a subject.

### 2. Description of the Related Art

In a magnetic resonance imaging (MRI) examination using an MRI apparatus, a radio frequency (RF) wave at a resonance frequency specific to an element is applied to an examination part of a subject, a generated nuclear magnetic resonance (NMR) signal is received by a reception coil (also referred to as an "RF coil"), and an image (MRI image) is generated from the received NMR signal.

Before the start of the MRI examination, a technician needs to manually set the reception coil at the examination part of the subject while paying attention to a condition of a patient, the positioning, the presence or absence of MRI contraindicated articles such as metal, the presence or absence of a cable loop that may lead to a burn, and the like.

In this way, since the reception coil is manually set, there is a lot of effort and time, which is one of causes of extending an examination time, and there is a demand for simplification of setting the reception coil and burden reduction from the related art.

JP2009-11837A discloses an assembly for attaching a local coil (reception coil) to a patient for a magnetic resonance diagnosis.

The assembly disclosed in JP2009-11837A comprises a reception coil (local coil) configured to receive an NMR signal, and a support device configured to accommodate the local coil and to attach the local coil to the patient.

The support device is configured as a gas-filled cushion, includes a device for changing a gas pressure, and has a shape of the cushion that changes in association with the gas pressure. That is, the support device presses a local antenna against the patient in accordance with the change in the shape of the cushion caused by the change in the gas pressure.

Specifically, the cushion is composed of a base plate formed of an elastic plastic plate, a non-ventilating hard foam having a notch and adhesively bonded to the base plate, and a ventilating soft foam filled in the notch, and a unit formed of the base plate, the hard foam, and the soft foam is pushed into a non-ventilating cover and vacuum tightly adheres thereto.

Then, by discharging air in the cover, the ventilating soft foam is contracted, the shape of the cushion is changed in relation to the contracted soft foam and the non-contracted non-ventilating hard foam, and the local coil is deformed to match a body of the patient. A degree of deformation or a deformation pressure is adjusted by a degree of vacuum generated during the discharge of air.

In addition, JP2011-30828A proposes a device that fixes a high-frequency coil to a subject. The high-frequency coil includes a flexible substrate and an exterior part provided to cover the substrate, and has foaming beads filled in a gap between the flexible substrate and the exterior part to an extent that the air is present. The high-frequency coil is fixed in a shape along the subject in a case in which the air in the exterior part is suctioned after the high-frequency coil is placed on the subject by an operator.

A support device for coils in a magnetic resonance imaging apparatus with features in the characterizing portion of Claim 1 is disclosed in US 2009/012389 A1. Further coil support arrangements related to the reception coil device of the present invention are disclosed in US 2014/021949 A1 and US 5 617 027 A.

### SUMMARY OF THE INVENTION

With the assembly described in JP2009-11837A, the air in the cover of the support device is discharged (suctioned), the shape of the cushion is changed according to the degree of vacuum in the cover, and the local coil can be deformed (wound) in accordance with the body of the patient. However, the winding cannot be released automatically, and it is necessary to open a valve and wait until the degree of vacuum in the cover reaches an ambient air pressure.

In addition, the assembly is not fixed to an examination table, and the technician needs to dispose the assembly in accordance with the examination part of the subject, and thus it takes effort and time.

In addition, in the device disclosed in JP2011-30828A, the high-frequency coil can be fixed (closely attached and fixed) along a surface shape of the subject by suctioning the air in the exterior part of the high-frequency coil, but the operator needs to place the high-frequency coil on the subject in advance (before the air in the exterior part is suctioned), and thus it takes effort and time.

The present invention has been made in view of such circumstances, and an object of the present invention is to provide a reception coil device and a magnetic resonance imaging apparatus that can automatically wind a reception coil around an examination part of a subject and release the winding.

The present invention is defined in Claim 1. Further advantageous features are set out in the dependent claims. The following aspects illustrate the configuration of the invention and examples related to it.

A first aspect relates to a reception coil device adapted to be provided in a magnetic resonance imaging apparatus and to receive a nuclear magnetic resonance signal, the reception coil device comprising: a reception coil adapted to receive the nuclear magnetic resonance signal; and a flexible band that accommodates the reception coil, has a part adapted to be fixed to an examination table, has a shape changing in response to supply and/or discharge of a fluid, and winds the reception coil around an examination part of a subject on the examination table or releases the winding of the reception coil.

An operator need only perform the positioning of the examination part of the subject on the flexible band fixed to the examination table before an MRI examination, and then the reception coil can be automatically wound around the examination part, and the winding of the reception coil can be automatically released after the MRI examination.

According to the invention, the flexible band has a part adapted to be fixed to the examination table, is formed by bonding together a first layer that accommodates the reception coil, a second layer that has a second bag-shaped structural portion and is adapated to be stretched by the fluid supplied to the second bag-shaped structural portion, and a third layer that has a third bag-shaped structural portion and is adapted to be curved by the fluid supplied to the third bag-shaped structural portion, and is adapted to stretch the reception coil to allow at least the winding of the reception coil around the examination part to be released in a case in which the fluid is discharged from the third bag-shaped structural portion and the fluid is supplied to the second bag-shaped structural portion, and is adapted to be curved to wind the reception coil around the examination part in a case in which the fluid is supplied to the third bag-shaped structural portion.

It is preferable that the first layer is disposed on an inner peripheral side of the flexible band that is curved. As a result, the reception coil can be wound closer to the examination part of the subject.

It is preferable that, in the flexible band, the first layer, the second layer, and the third layer overlap to be bonded together in this order from an innermost peripheral side of the flexible band, or the second layer, the first layer, and the third layer overlap to be bonded together in this order from the innermost peripheral side of the flexible band.

In another aspect it is preferable that the first layer is disposed on an innermost peripheral side of the flexible band that is curved, and the second layer and the third layer are disposed on an outer peripheral side with respect to the first layer. As a result, the reception coil can be wound closer to the examination part of the subject.

The reception coil device may include a first bag-shaped structural portion that accommodates the reception coil.

It is preferable that the reception coil device further comprises: a fluid pressure circuit including a fluid pressure source adapted to supply and/or discharge the fluid, a first tube and a second tube that are disposed between the fluid pressure source and the second bag-shaped structural portion and between the fluid pressure source and the third bag-shaped structural portion, and a solenoid valve that is disposed in the first tube and the second tube and adapted to switch directions of the fluids flowing through the first tube and the second tube; and a controller configured to control the fluid pressure source and the solenoid valve, and the controller is configured to: in a case in which an instruction to wind the reception coil is received, control the fluid pressure source and the solenoid valve to discharge the fluid from the second bag-shaped structural portion via the first tube and the solenoid valve, supply the fluid from the fluid pressure source to the third bag-shaped structural portion via the solenoid valve and the second tube, and wind the reception coil around the examination part; and in a case in which an instruction to release the winding of the reception coil is received, discharge the fluid from the third bag-shaped structural portion via the second tube and the solenoid valve and supply the fluid from the fluid pressure source to the second bag-shaped structural portion via the solenoid valve and the first tube to release the winding of the reception coil around the examination part.

An eleventh aspect relates to the reception coil device according to the ninth or tenth aspect, in which it is preferable that the controller is configured to, as the instruction to wind the reception coil, receive an instruction to raise the examination table or a first timing in control of raising the examination table. Accordingly, the reception coil can be automatically wound around the examination part at a desired timing even in a case in which the operator does not issue the instruction to wind the reception coil.

A twelfth aspect relates to the reception coil device according to the ninth or tenth aspect, in which it is preferable that the controller is configured to, as the instruction to release the winding of the reception coil, receive an instruction to pull out the examination table from a gantry of the magnetic resonance imaging apparatus or a second timing in control of pulling out the examination table. As a result, even in a case in which the operator does not issue the instruction to release the winding of the reception coil, the winding of the reception coil around the examination part can be automatically released at a desired timing.

A thirteenth aspect relates to a magnetic resonance imaging apparatus comprising the reception coil device according to any one of the first to twelfth aspects.

According to these aspects, the reception coil can be automatically wound around the examination part of the subject on the examination table, and the winding of the reception coil can be automatically released, so that the setting of the reception coil performed by the operator can be simplified and the burden on the operator can be reduced.

### BRIEF DESCRIPTION OF THE DRAWINGS

Fig. 1 is a perspective view showing an appearance of a magnetic resonance imaging apparatus (MRI apparatus) comprising a reception coil device according to an embodiment of the present invention.
Fig. 2 is a diagram showing a schematic configuration of an inside of the MRI apparatus shown in Fig. 1.
Fig. 3 is a diagram showing a first embodiment of the reception coil device, which is not an embodiment of the present invention but an example useful for its understanding.
Fig. 4 is a view showing a main part of a second embodiment of the reception coil device according as an embodiment of the present invention.
Fig. 5 is a developed view in which each bag-shaped structural portion constituting a flexible band shown in Fig. 4 is separated and arranged.
Figs. 6A to 6D are transition diagrams showing an outline of an action of the flexible band accommodating the reception coil, an operation of an examination table, and the like.
Fig. 7 is a diagram showing an example of a drive of the flexible band shown in Fig. 4 and a controller.

### DESCRIPTION OF THE PREFERRED EMBODIMENTS

Hereinafter, preferred embodiments of a reception coil device and a magnetic resonance imaging apparatus according to an embodiment of the present invention and an example useful for its understanding will be described with reference to the accompanying drawings.

### Appearance of MRI Apparatus

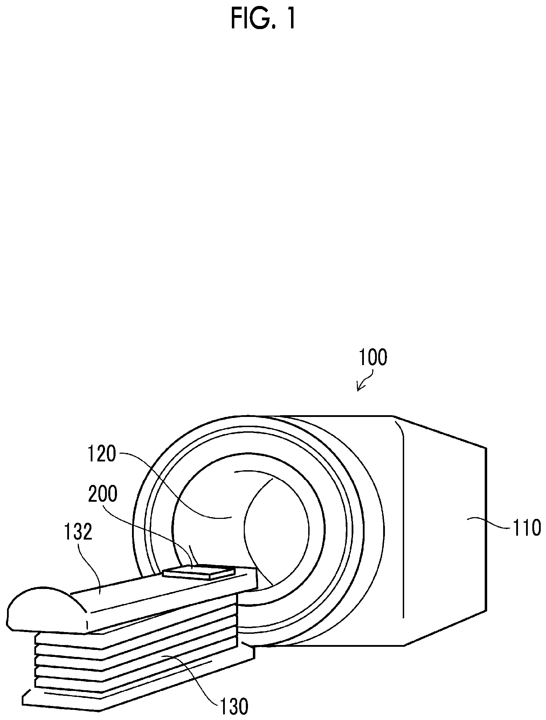

Fig. 1 is a perspective view showing an appearance of a magnetic resonance imaging apparatus (MRI apparatus) comprising a reception coil device according to the embodiment of the present invention.

The MRI apparatus 100 shown in Fig. 1 comprises a gantry 110, an examination table 130 comprising a top plate 132 disposed on a front side of a bore 120 which is a cylindrical imaging space provided in the gantry 110, and a reception coil device 200 having a part fixed to the examination table 130.

### Internal Configuration of MRI Apparatus

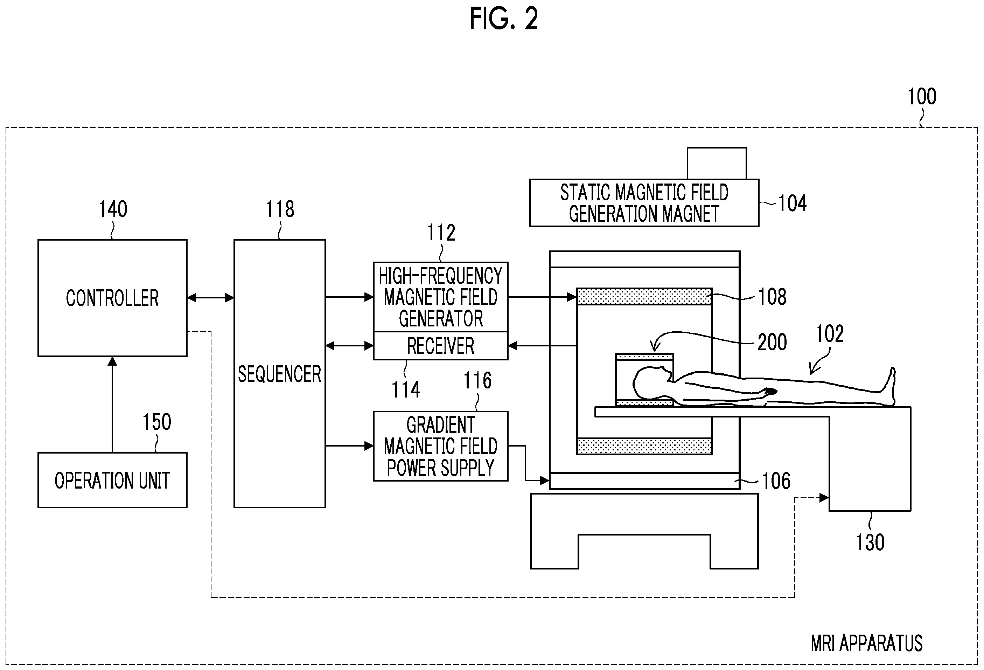

Fig. 2 is a diagram showing a schematic configuration of an inside of the MRI apparatus shown in Fig. 1.

As shown in Fig. 2, the MRI apparatus 100 comprises a static magnetic field generation magnet 104 that generates a uniform static magnetic field in the imaging space in which a subject 102 is disposed, a gradient magnetic field coil 106 that generates a gradient magnetic field in the imaging space, a radio frequency (RF) coil (transmission coil) 108 that generates a high-frequency magnetic field that generates a nuclear magnetic resonance signal (NMR signal) in an atomic nucleus of an atom constituting a tissue of the subject 102, and a reception coil device 200 comprising a reception coil that detects the NMR signal generated from the subject 102.

A part of the reception coil device 200 is fixed to the top plate 132 (Fig. 1) of the examination table 130. The subject 102 is usually disposed in the imaging space in a state of lying on the top plate 132 of the examination table 130. It should be noted that the details of the reception coil device 200 will be described later.

A sequencer 118 transmits commands to a high-frequency magnetic field generator 112 and a gradient magnetic field power supply 116 in accordance with an imaging sequence (pulse sequence), to generate the high-frequency magnetic field and the gradient magnetic field, respectively. The generated high-frequency magnetic field is applied to the subject 102 as a pulsed high-frequency magnetic field (RF pulse) via the transmission coil 108. The NMR signal generated from the subject 102 is received by the reception coil device 200 and is detected by a receiver 114.

It should be noted that the gradient magnetic field coil 106 is configured by gradient magnetic field coils of three directions X, Y, and Z, and generates the gradient magnetic field in each direction in response to the signal from the gradient magnetic field power supply 116.

A nuclear magnetic resonance frequency (detection reference frequency f0) used as a reference for the detection in the receiver 114 is set by the sequencer 118. The sequencer 118 controls each unit to operate at a timing and intensity programmed in advance. Among the programs, a program that particularly describes the RF pulse, the gradient magnetic field, and the timing or the intensity of the signal reception is called the pulse sequence.

Various pulse sequences depending on the purpose are known, but the detailed description thereof will be omitted here.

A controller 140 controls an operation of the MRI apparatus 100 via the sequencer 118, and receives the signal detected by the receiver 114 and performs various types of signal processing, such as image reconstruction. It should be noted that the receiver 114 quadrature phase-detects an echo signal that is an analog wave based on the set detection reference frequency f0, converts the echo signal into raw data, and then transmits the raw data to the controller 140, and the raw data is also referred to as the echo signal or measurement data.

The controller 140 can be configured by using a computer. The computer applied to the controller 140 may be a personal computer or a workstation.

The controller 140 receives various instruction inputs from an operation unit 150, collectively controls the respective units of the MRI apparatus 100, and performs processing of converting the echo signal in a spatial frequency domain received via the sequencer 118 into an image in the real space by performing inverse Fourier transformation, and the like to generate an MRI image.

The operation unit 150 includes a mouse, a keyboard, and the like, and functions as a part of a graphical user interface (GUI) that receives an input from an operator by using a display operation window of a display (not shown).

That is, the operation unit 150 and the display function as the GUI for the operator to input the activation, the stop (temporary stop), the pulse sequence selection, the imaging conditions, the processing conditions, and the like of the MRI apparatus 100. In addition, the operation unit 150 of the present example functions as an operation unit (operation button) used in a case in which the operator raises the examination table 130 (top plate 132) at the start of the examination or in a case in which the subject pulls out the examination table 130 (top plate 132) from the gantry 110 at the end of the examination.

### Reception Coil Device

### First Embodiment

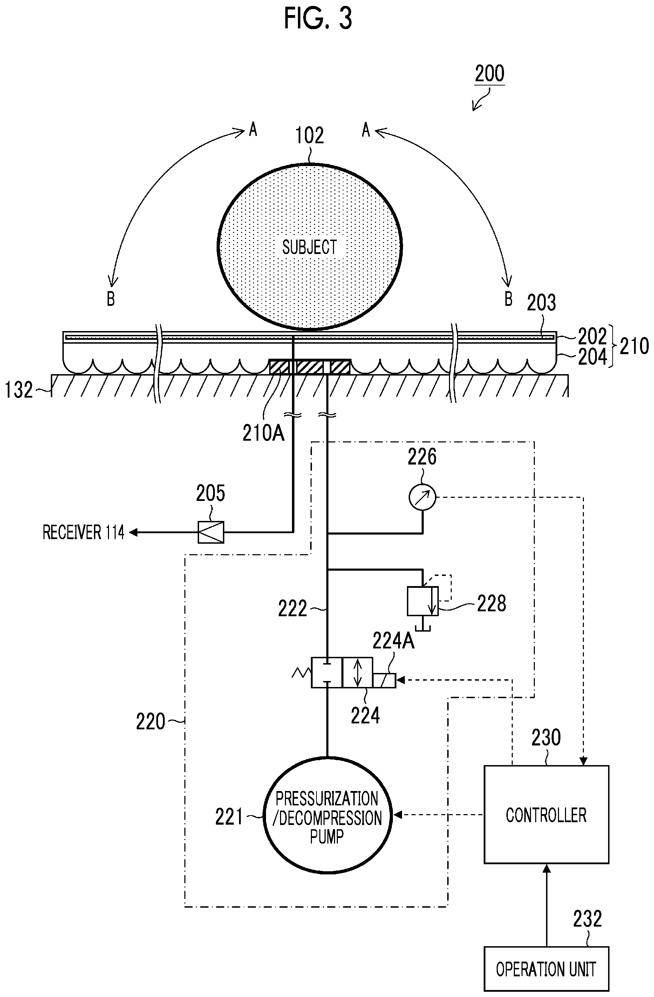

Fig. 3 is a diagram showing a first embodiment of the reception coil device which is not an embodiment of the present invention but an example useful for its understanding.

The reception coil device 200 shown in Fig. 3 is composed of a reception coil 203, a flexible band 210, a fluid pressure circuit 220, a controller 230, and an operation unit 232.

The reception coil 203 is formed of, for example, a flexible wiring pattern or the like, and is wound around the examination part of the subject 102. The nuclear magnetic resonance signal (NMR signal) received by the reception coil 203 during the examination is transmitted to the receiver 114 via an amplifier 205.

A fixing portion 210A, which is a part of the flexible band 210, is fixed to the examination table 130 (top plate 132).

The flexible band 210 is formed by bonding together a first layer having a first bag-shaped structural portion 202 that accommodates the reception coil 203 and a second layer that has a bag-shaped structural portion 204 and is curved or stretched by the fluid supplied to or discharged from the bag-shaped structural portion 204. It should be noted that the fluid supplied to or discharged from the bag-shaped structural portion 204 is air in the present example, but the present invention is not limited thereto.

A plurality of pleats are formed on a surface of the bag-shaped structural portion 204, which is opposite to the first layer (first bag-shaped structural portion 202), and in a case in which compressed air is supplied to the bag-shaped structural portion 204 and the inside of the bag-shaped structural portion 204 is pressurized, the pleats spread. As a result, the bag-shaped structural portion 204 is deformed such that the flexible band 210 is curved with the first layer (reception coil 203) on the inner side, due to an area difference between an inner surface on the first layer side and an outer surface having the pleats.

That is, the flexible band 210 is wound around the subject 102 with both ends thereof being moved (raised) in a direction of an arrow A with the fixing portion 210A as the center on Fig. 3.

On the other hand, in a case in which the air is supplied to the bag-shaped structural portion 204 and the air is discharged from the bag-shaped structural portion 204 in a state in which the flexible band 210 is wound around the subject 102, the winding force of the bag-shaped structural portion 204 is lost.

As a result, the flexible band 210 is moved (is lowered) in a direction of an arrow B and is stretched along the top plate 132. That is, as shown in Fig. 3, the flexible band 210 is stretched, and the winding of the reception coil 203 is released.

In this way, the flexible band 210 has a shape changing in response to the supply and/or discharge of the compressed air to and from the bag-shaped structural portion 204, and winds the reception coil around the examination part of the subject 102 on the examination table 130 or releases the winding of the reception coil.

The fluid pressure circuit 220 is composed of a pressurization/decompression pump 221, a tube 222, a solenoid valve 224, a pressure sensor 226, and a relief valve 228.

The pressurization/decompression pump 221 functions as a fluid pressure source that supplies and/or discharges the fluid, and is a pressure source for supplying air to the bag-shaped structural portion 204 of the flexible band 210 to curve the flexible band 210 or discharging (suctioning) the air from the bag-shaped structural portion 204 to stretch the flexible band 210.

The tube 222 is a pipe that connects a supply/exhaust port of the bag-shaped structural portion 204 of the flexible band 210 and the pressurization/decompression pump 221 to each other.

The solenoid valve 224 is a two-direction two-position solenoid valve disposed in the tube 222. In a case in which a solenoid 224A is excited, the solenoid valve 224 is turned on to enable switching of the supply or discharge of the air to or from the bag-shaped structural portion 204 via the tube 222, and in a case in which the solenoid 224A is demagnetized, the solenoid valve 224 is turned off to block the flow of the air.

The pressure sensor 226 detects a pressure in the bag-shaped structural portion 204 and outputs a pressure signal indicating the detected pressure to the controller 230.

The relief valve 228 functions as a safety valve that is opened to discharge the air in a case in which the pressure in the bag-shaped structural portion 204 reaches an abnormal pressure.

The controller 230 is a unit that controls the pressurization/decompression pump 221 and the solenoid valve 224 in response to an instruction to wind the reception coil 203 or an instruction to release the winding of the reception coil 203 from the operation unit 232, and that winds the reception coil 203 around the examination part of the subject 102 or releases the winding of the reception coil 203 around the examination part.

That is, in a case in which the instruction to wind the reception coil 203 is received from the operation unit 232, the controller 230 turns on the solenoid valve 224, and then performs control of driving the pressurization/decompression pump 221 such that the compressed air is ejected from the pressurization/decompression pump 221. Thereafter, in a case in which the controller 230 detects that the pressure in the bag-shaped structural portion 204 of the flexible band 210 has reached a preset reference pressure based on a detection signal of the pressure sensor 226, the controller 230 stops the pressurization/decompression pump 221, and then turns off the solenoid valve 224.

As a result, the controller 230 can automatically wind the reception coil 203 around the examination part of the subject 102 together with the flexible band 210.

It should be noted that it is preferable that the reference pressure is set such that the flexible band 210 (reception coil 203) is curved and wound around the examination part of the subject 102 without hindering a blood flow of the examination part.

On the other hand, in a case in which the instruction to release the winding of the reception coil 203 is received from the operation unit 232, the controller 230 turns on the solenoid valve 224, and then performs control of driving the pressurization/decompression pump 221 such that the air in the bag-shaped structural portion 204 is discharged (suctioned). Thereafter, in a case in which the controller 230 detects that the pressure in the bag-shaped structural portion 204 of the flexible band 210 has reached a pressure equal to or lower than the atmospheric pressure based on the detection signal of the pressure sensor 226, the controller 230 stops the pressurization/decompression pump 221, and then turns off the solenoid valve 224.

As a result, the controller 230 can stretch the reception coil 203 together with the flexible band 210 and automatically release the winding of the reception coil 203 around the examination part.

It should be noted that, in the present example, a signal cable of the reception coil 203 and the tube 222 connected to the bag-shaped structural portion 204 extend downward from the top plate 132 via the fixing portion 210A of the flexible band 210, but it is needless to say that the signal cable of the reception coil 203 and the tube 222 are wired and piped so as not to hinder the movement of the top plate 132 in a case of the raising and lowering of the examination table 130 (top plate 132) and the pulling in and out and removal of the bore 120 of the top plate 132.

In addition, the signal cable of the reception coil 203 and the tube 222 from the flexible band 210 are not limited to being led out into the examination table 130 via the fixing portion 210A of the flexible band 210, and for example, a part of the signal cable of the reception coil 203 and a part of the tube 222 may be disposed along the top plate 132 or the examination table 130.

### Second Embodiment

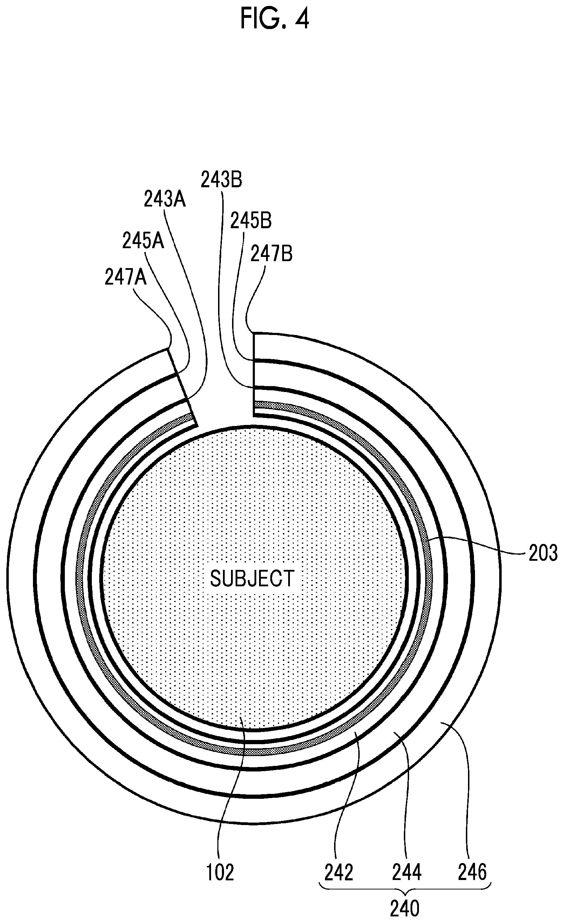

Fig. 4 is a diagram showing a main part of a second embodiment of the reception coil device as an embodiment of the present invention, and shows a state in which the flexible band constituting the reception coil device is wound around the subject.

The flexible band 240 of the reception coil device shown in Fig. 4 is formed by bonding together a first layer having a first bag-shaped structural portion 242 that accommodates the reception coil 203, a second layer that has a second bag-shaped structural portion 244 and is stretched by the fluid supplied to the second bag-shaped structural portion 244, and a third layer that has a third bag-shaped structural portion 246 and is curved by the fluid supplied to the third bag-shaped structural portion 246.

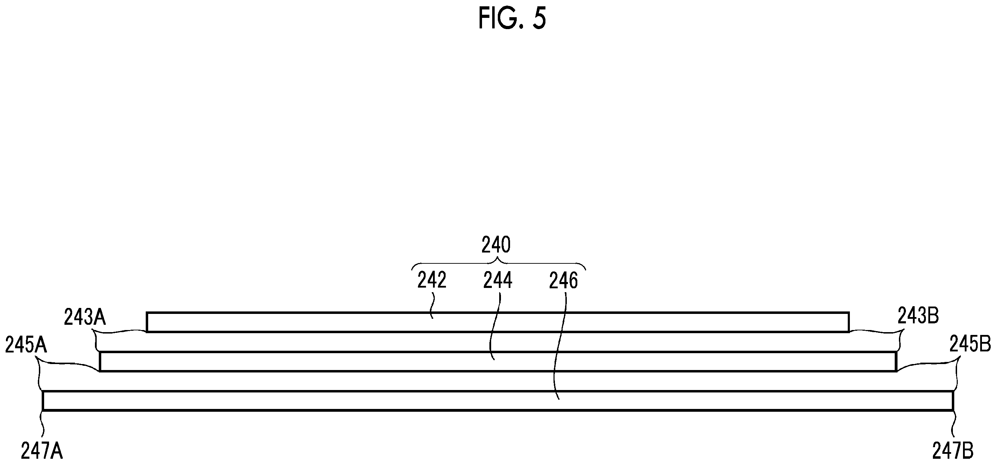

Fig. 5 is a developed view in which each bag-shaped structural portion constituting the flexible band shown in Fig. 4 is separated and arranged.

As shown in Fig. 5, the first bag-shaped structural portion 242 on the innermost peripheral side of the flexible band 240 has the shortest length, and the second bag-shaped structural portion 244 and the third bag-shaped structural portion 246 are formed to have longer lengths in this order.

In addition, both ends of the first bag-shaped structural portion 242 and the second bag-shaped structural portion 244 are bonded together at end points 243A and 243B, and both ends of the second bag-shaped structural portion 244 and the third bag-shaped structural portion 246 are bonded together at end points 245A and 245B.

Therefore, in a case in which the fluid (air) is discharged from the second bag-shaped structural portion 244 and the fluid (air) is supplied to the third bag-shaped structural portion 246, the inner side length of the third bag-shaped structural portion 246 is restrained by the length of the second bag-shaped structural portion 244 due to the end points 245A and 245B that are bonded to the second bag-shaped structural portion 244, but the end points 247A and 247B on the outer side are not restrained, so that the third bag-shaped structural portion 246 is stretched to the original length.

As a result, the third bag-shaped structural portion 246 has a difference in length between the inner side and the outer side, is deformed to be curved toward the inside, and winds the flexible band 210 (reception coil 203) around the examination part of the subject 102 as shown in Fig. 4.

Meanwhile, in a case in which the air is discharged from the third bag-shaped structural portion 246 and the air is supplied to the second bag-shaped structural portion 244, the inner side length of the second bag-shaped structural portion 244 is restrained by the length of the first bag-shaped structural portion 242 due to the end points 243A and 243B that are bonded to the first bag-shaped structural portion 242, but the end points 245A and 245B on the outer side are not restrained, so that the second bag-shaped structural portion 244 is stretched to the original length.

As a result, the second bag-shaped structural portion 244 is stretched and the flexible band 240 is stretched as a whole, but in the present example, the inner length of the second bag-shaped structural portion 244 is restrained by the length of the first bag-shaped structural portion 242 due to the end points 243A and 243B bonded to the first bag-shaped structural portion 242, so that the second bag-shaped structural portion 244 has a difference in length between the inner side and the outer side, and is deformed to be curved toward the inside. However, it is preferable that a difference in length between the first bag-shaped structural portion 242 and the second bag-shaped structural portion 244 is designed or the air pressure supplied to the second bag-shaped structural portion 244 is adjusted, such that the first bag-shaped structural portion 242 having the reception coil 203 is not closely attached to the examination part of the subject 102 (preferably, the subject 102 is not restrained by the flexible band 240).

In addition, since the end points 243A and 243B of the first bag-shaped structural portion 242 and the second bag-shaped structural portion 244 are bonded together, the first bag-shaped structural portion 242 is stretched with the stretch of the second bag-shaped structural portion 244.

In this way, the second bag-shaped structural portion 244 is stretched in a curved shape, so that the first bag-shaped structural portion 242 that accommodates the reception coil 203 can also be stretched in a curved shape, and the preparation for the winding of the reception coil 203 around the examination part or the release of the winding can be made.

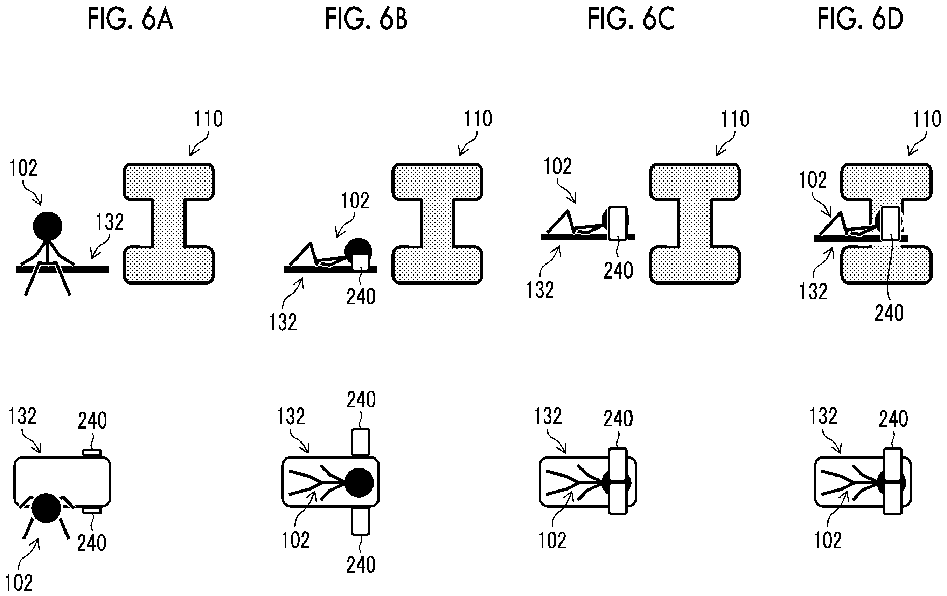

Figs. 6A to 6D are transition diagrams showing an outline of an action of the flexible band accommodating the reception coil, an operation of the examination table, and the like.

Fig. 6A shows a state in which the subject 102 is sitting on the top plate 132 of the examination table before the examination. In this case, the air is not supplied to the flexible band 240 shown in Fig. 4 and the like. The top plate 132 is located at a descending end.

Subsequently, as shown in Fig. 6B, the subject 102 lies on the top plate 132 in a supine position. It is preferable that the operator adjusts a position or the like of the subject 102 lying on the top plate 132 in a supine position. This is for ensuring that the flexible band 240 is correctly wound around the examination part of the subject 102.

Thereafter, the operator operates an operation unit described later to issue the winding instruction of the flexible band 240 (reception coil 203) to wind the flexible band 240 around the examination part of the subject 102. In a case in which the instruction to wind the reception coil 203 is issued, first, the air is supplied to the second bag-shaped structural portion 244 of the flexible band 240, whereby the flexible band 240, which has been deflated as a whole, is stretched in a curved shape (Fig. 6B).

Subsequently, as shown in Fig. 6C, the top plate 132 is raised to a height at which the top plate 132 can be pulled in and out of the bore of the gantry 110 of the MRI apparatus. In addition, the air is supplied to the third bag-shaped structural portion 246 of the flexible band 240 and the air is discharged from the second bag-shaped structural portion 244 to automatically wind the flexible band 240 around the examination part of the subject 102. It should be noted that, in the example shown in Fig. 6, the examination part of the subject 102 is the head. It should be noted that the flexible band 240 may be automatically wound around the examination part of the subject 102 by supplying the air to the third bag-shaped structural portion 246 without discharging the air from the second bag-shaped structural portion 244. In this case, it is preferable to appropriately adjust the air pressure supplied to the second bag-shaped structural portion 244 and the air pressure supplied to the third bag-shaped structural portion 246.

Next, as shown in Fig. 6D, the top plate 132 is inserted into the bore of the gantry 110 of the MRI apparatus. As a result, it is possible to perform the MRI examination of the examination part of the subject 102. It should be noted that the control of the examination table and the winding of the flexible band 240 in Figs. 6B and 6C may be performed simultaneously.

Thereafter, in a case in which the examination has ended, the control of the examination table and the control of the flexible band 240 are performed in the reverse order of the above.

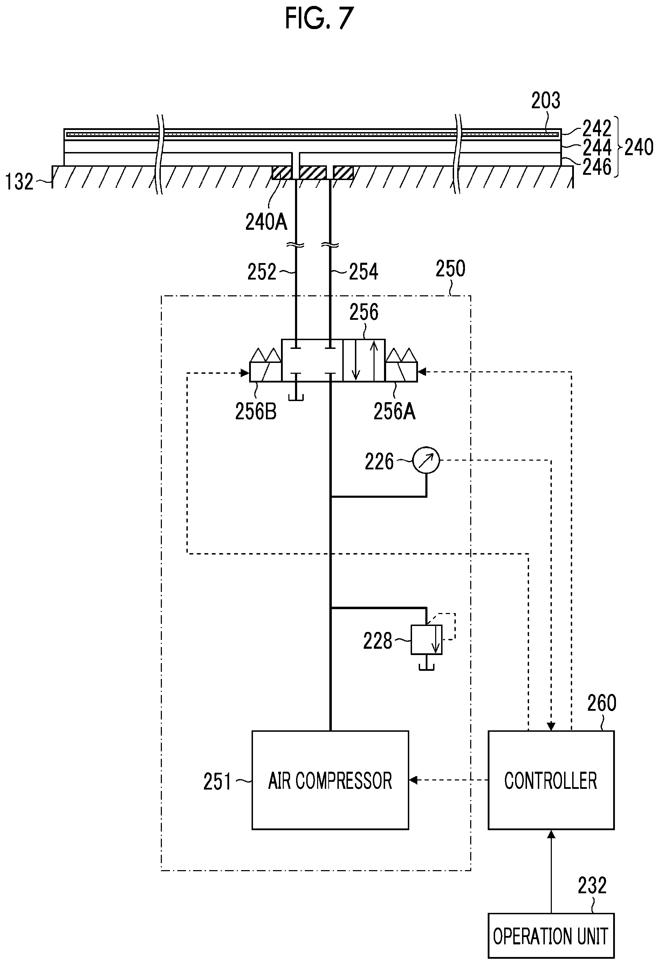

Fig. 7 is a diagram showing an example of a drive of the flexible band shown in Fig. 4 and a controller, and the reception coil device according to the second embodiment is composed of the flexible band 240, a fluid pressure circuit 250, a controller 260, and the operation unit 232.

In Fig. 7, a part of the outer side of the third bag-shaped structural portion 246 of the flexible band 240 is fixed to the examination table 130 (top plate 132) by the fixing portion 240A. The fixing portion 240A may be configured to be attachable to and detachable from the top plate 132.

The fluid pressure circuit 250 is composed of an air compressor 251, a first tube 252, a second tube 254, a solenoid valve 256, the pressure sensor 226, and the relief valve 228.

One end side of the first tube 252 and one end side the second tube 254 are connected to the supply/exhaust ports of the second bag-shaped structural portion 244 and the third bag-shaped structural portion 246, and the other end side is connected to the air compressor 251 or an exhaust port via the solenoid valve 256.

The solenoid valve 256 is a four-direction three-position solenoid valve disposed in the first tube 252 and the second tube 254.

In a case in which a solenoid 256A is excited, the solenoid valve 256 can supply the compressed air from the air compressor 251 to the third bag-shaped structural portion 246 via the solenoid valve 256 and the second tube 254, and can discharge the air from the second bag-shaped structural portion 244 to the atmosphere via the first tube 252 and the solenoid valve 256.

In a case in which a solenoid 256B is excited, the solenoid valve 256 can supply the compressed air from the air compressor 251 to the second bag-shaped structural portion 244 via the solenoid valve 256 and the first tube 252, and can discharge the air from the third bag-shaped structural portion 246 to the atmosphere via the second tube 254 and the solenoid valve 256.

The pressure sensor 226 detects the air pressure supplied from the air compressor 251 to the second bag-shaped structural portion 244 or the third bag-shaped structural portion 246, and outputs the pressure signal indicating the detected air pressure to the controller 260.

The relief valve 228 functions as a safety valve that is opened to discharge the air in a case in which the air pressure supplied to the second bag-shaped structural portion 244 or the third bag-shaped structural portion 246 is an abnormal pressure.

The controller 260 is a unit that controls the air compressor 251 and the solenoid valve 256 in response to an instruction to wind the reception coil 203 or an instruction to release the winding of the reception coil 203 from the operation unit 232, and that winds the flexible band 240 (reception coil 203) around the examination part of the subject 102 or releases the winding of the reception coil 203 around the examination part.

That is, in a case in which the instruction to wind the reception coil 203 is received from the operation unit 232, the controller 260 excites the solenoid 256A of the solenoid valve 256, drives the air compressor 251, and then performs control of driving the pressurization/decompression pump 221 such that compressed air is ejected from the air compressor 251.

As a result, the compressed air ejected from the air compressor 251 is supplied to the third bag-shaped structural portion 246 via the solenoid valve 256 and the second tube 254, and the air in the second bag-shaped structural portion 244 is discharged via the first tube 252 and the solenoid valve 256.

Thereafter, in a case in which the controller 260 detects that the pressure in the third bag-shaped structural portion 246 of the flexible band 240 has reached the preset reference pressure based on the detection signal of the pressure sensor 226, the controller 260 stops the air compressor 251, demagnetizes the solenoid 256A of the solenoid valve 256 and returns a spool of the solenoid valve 256 to the position shown in Fig. 7.

As described above, by supplying the compressed air to the third bag-shaped structural portion 246, a difference in length between the outer peripheral side and the inner peripheral side of the third bag-shaped structural portion 246 is generated, and the third bag-shaped structural portion 246 is curved inward as shown in Fig. 4 to wind the flexible band 240 (reception coil 203) around the subject 102. It should be noted that, since the inner peripheral side length of the third bag-shaped structural portion 246 is restrained by the length of the second bag-shaped structural portion 244, in a case in which the compressed air is supplied into the third bag-shaped structural portion 246, a difference in length between the outer peripheral side and the inner peripheral side of the third bag-shaped structural portion 246 is generated.

Meanwhile, in a case in which the instruction to release the winding of the reception coil 203 is received from the operation unit 232, the controller 260 excites the solenoid 256B of the solenoid valve 256, drives the air compressor 251, and then performs control of driving the pressurization/decompression pump 221 such that compressed air is ejected from the air compressor 251.

As a result, the compressed air ejected from the air compressor 251 is supplied to the second bag-shaped structural portion 244 via the solenoid valve 256 and the first tube 252, and the air in the third bag-shaped structural portion 246 is discharged via the second tube 254 and the solenoid valve 256.

Thereafter, in a case in which the controller 260 detects that the pressure in the second bag-shaped structural portion 244 of the flexible band 240 has reached the reference pressure based on the detection signal of the pressure sensor 226, the controller 260 stops the air compressor 251, demagnetizes the solenoid 256A of the solenoid valve 256 and returns a spool of the solenoid valve 256 to the position shown in Fig. 7.

The end points 243A and 243B on the inner side of the second bag-shaped structural portion 244 are restrained by the first bag-shaped structural portion 242, whereas the end points 243A and 243B on the inner side of the second bag-shaped structural portion 244 are not restrained by the third bag-shaped structural portion 246, so that the second bag-shaped structural portion 244 has a difference in length between the inner side and the outer side and is deformed to be curved toward the inner side. However, since the second bag-shaped structural portion 244 is stretched (spreads) in a curved shape so as not to restrain the examination part, the winding of the reception coil 203 around the examination part is released.

It should be noted that, although the signal cable for acquiring the NMR signal from the reception coil 203 is not shown in Fig. 7, the signal cable, the first tube 252, and the second tube 254 are wired and piped so as not to hinder the movement of the top plate 132 of the examination table. In addition, in the fluid pressure circuit 250 shown in Fig. 7, an accumulator may be provided on an outlet side of the air compressor 251, and the air compressor 251 may be driven in a case in which the compressed air accumulated in the accumulator has a pressure equal to or less than the reference pressure.

### Other Embodiments

The controller 230 and the controller 260 shown in Figs. 3 and 7 control the fluid pressure circuits 220 and 250 in response to the instruction to wind the reception coil 203 or the instruction to release the winding of the reception coil 203 from the operation unit 232 operated by the operator, and executes the winding of the reception coil 203 around the subject and the release of the winding, but the present invention is not limited thereto, and the fluid pressure circuits 220 and 250 may be controlled by using an instruction to operate the examination table 130 or a predetermined timing of the operation of the examination table as a trigger.

For example, in a case in which the controller 140 shown in Fig. 2 receives an instruction to raise the examination table 130 from the operation unit 150 and performs control of raising the examination table 130, the controllers 230 and 260 may receive the instruction to raise the examination table 130 as the instruction to wind the reception coil and control the fluid pressure circuits 220 and 250, or may receive a first timing (for example, timing at which the examination table 130 is raised) in the control of raising the examination table 130 as the instruction to wind the reception coil and control the fluid pressure circuits 220 and 250.

Similarly, in a case in which the controller 140 shown in Fig. 2 receives an instruction to pull out the examination table 130 (top plate 132) from the inside of the bore 120 of the gantry 110 of the MRI apparatus 100 from the operation unit 150 and performs control of pulling out the top plate 132 from the inside of the bore 120, the controllers 230 and 260 may receive the instruction to pull out the examination table 130 as the instruction to release the winding of the reception coil and control the fluid pressure circuits 220 and 250, or may receive a second timing (for example, a timing at which the pulling out of the top plate 132 of the examination table 130 from the gantry 110 is completed) in the control of pulling out the examination table 130 as the instruction to release the winding of the reception coil and control the fluid pressure circuits 220 and 250.

As a result, the operator does not need to issue the instruction to wind the reception coil or the instruction to release the winding of the reception coil via the operation unit, and the burden on the operator can be further reduced.

It should be noted that, in the flexible band 240 according to the second embodiment, as shown in Figs. 4 and 5, the first bag-shaped structural portion 242 is provided as the first layer on the innermost periphery, the second bag-shaped structural portion 244 for stretching the flexible band 240 is provided as the second layer on the outer peripheral side of the first bag-shaped structural portion 242, and the third bag-shaped structural portion 246 for curving the flexible band 240 is provided as the third layer on the outer peripheral side of the second bag-shaped structural portion 244, but the present invention is not limited thereto, and the third bag-shaped structural portion 246 may be provided between the first bag-shaped structural portion 242 and the second bag-shaped structural portion 244.

That is, the first bag-shaped structural portion 242 of the first layer may be disposed on the innermost peripheral side of the flexible band 240, the order of the second bag-shaped structural portion 244 and the third bag-shaped structural portion 246 disposed on the outer peripheral side of the first bag-shaped structural portion 242 may be reversed, and the third layer and the second layer may overlap to be bonded together in this order on the outer peripheral side of the first bag-shaped structural portion 242 (first layer). In this case, the end points of both ends of each of bag-shaped structural portion need only be fixed as shown in Fig. 5 by making the length of the first bag-shaped structural portion 242 of the first layer shorter than the lengths of the second bag-shaped structural portion 244 and the third bag-shaped structural portion 246, and making the lengths of the second bag-shaped structural portion 244 and the third bag-shaped structural portion 246 the same.

In addition, since the reception coil 203 is accommodated in the first bag-shaped structural portion 242 on the innermost peripheral side, the flexible band 240 can bring the reception coil 203 close to the examination part of the subject 102 in a case of being curved.

### Others

In the present embodiment, one flexible band accommodating the reception coil used for the examination of the head is provided on the examination table, but two or more flexible bands used for the examination of other examination parts (chest, abdomen, joint of limbs, and the like) of the subject may be installed on the examination table, or a desired flexible band may be attachable to the examination table. In this case, the fluid pressure circuit, the controller, and the like for driving the flexible band can be commonly used for the respective flexible bands.

In addition, in the present embodiment, the case is described in which a gas such as air is supplied as the fluid supplied to the flexible band, but the present invention is not limited to this. A liquid such as water may be supplied as the fluid, and the type of the fluid is not limited.

It is needless to say that the present invention is not limited to the above-described embodiments, and various modifications can be made without departing from the gist of the present invention.

### Explanation of References

100: MRI apparatus
102: subject
110: gantry
120: bore
130: examination table
132: top plate
140, 230, 260: controller
150, 232: operation unit
200: reception coil device
203: reception coil
210: flexible band
220: fluid pressure circuit
240: flexible band

## Claims

1. A reception coil device adapted to be provided in a magnetic resonance imaging apparatus (100) and to receive a nuclear magnetic resonance signal, the reception coil device (200) comprising:
a reception coil (203) adapted to receive the nuclear magnetic resonance signal; and
a flexible band (210) that accommodates the reception coil, has a shape changing in response to supply and/or discharge of a fluid, and is adapted to wind the reception coil around an examination part of a subject (102) on an examination table of the magnetic resonance imaging apparatus (100) or to release the winding of the reception coil,
**characterized in that** the flexible band has a part adapted to be fixed to the examination table (130),
is formed by bonding together a first layer that accommodates the reception coil, a second layer that has a second bag-shaped structural portion (244) and is adapted to be stretched by the fluid supplied to the second bag-shaped structural portion, and a third layer that has a third bag-shaped structural portion (246) and is adapted to be curved by the fluid supplied to the third bag-shaped structural portion, and
is adapted to stretch the reception coil to allow at least the winding of the reception coil around the examination part to be released in a case in which the fluid is discharged from the third bag-shaped structural portion and the fluid is supplied to the second bag-shaped structural portion, and is adapted to be curved to wind the reception coil around the examination part in a case in which the fluid is supplied to the third bag-shaped structural portion.

2. The reception coil device according to claim 1,
wherein, in the flexible band (210), the first layer, the second layer, and the third layer overlap to be bonded together in this order from an innermost peripheral side of the flexible band, or the second layer, the first layer, and the third layer overlap to be bonded together in this order from the innermost peripheral side of the flexible band.

3. The reception coil device according to claim 1 or 2,
wherein the first layer is disposed on an innermost peripheral side of the flexible band (210) that is curved, and the second layer and the third layer are disposed on an outer peripheral side with respect to the first layer.

4. The reception coil device according to any one of claims 1 to 3,
wherein the first layer includes a first bag-shaped structural portion (242) that accommodates the reception coil (203).

5. The reception coil device according to any one of claims 1 to 4, further comprising:
a fluid pressure circuit (250) including a fluid pressure source (251) adapted to supply and/or discharge the fluid, a first tube (252) and a second tube (254) that are disposed between the fluid pressure source and the second bag-shaped structural portion (244) and between the fluid pressure source and the third bag-shaped structural portion (246), and a solenoid valve (256) that is disposed in the first tube and the second tube and adapted to switch directions of the fluids flowing through the first tube and the second tube; and
a controller (260) configured to control the fluid pressure source and the solenoid valve,
wherein the controller is configured to: in a case in which an instruction to wind the reception coil (203) is received, control the fluid pressure source and the solenoid valve to discharge the fluid from the second bag-shaped structural portion via the first tube and the solenoid valve, supply the fluid from the fluid pressure source to the third bag-shaped structural portion via the solenoid valve and the second tube, and wind the reception coil around the examination part; and in a case in which an instruction to release the winding of the reception coil is received, discharge the fluid from the third bag-shaped structural portion via the second tube and the solenoid valve and supply the fluid from the fluid pressure source to the second bag-shaped structural portion via the solenoid valve and the first tube to release the winding of the reception coil around the examination part.

6. The reception coil device according to claim 5,
wherein the controller (260) is configured to, as the instruction to wind the reception coil (203), receive an instruction to raise the examination table (130) or a first timing in control of raising the examination table.

7. The reception coil device according to claim 5,
wherein the controller (260) is configured to, as the instruction to release the winding of the reception coil (203), receive an instruction to pull out the examination table (130) from a gantry (110) of the magnetic resonance imaging apparatus (100) or a second timing in control of pulling out the examination table.

8. A magnetic resonance imaging apparatus comprising:
the reception coil device (200) according to any one of claims 1 to 7.

## Patentansprüche

1. Empfangsspulenvorrichtung, die so angepasst ist, dass sie bei einer Magnetresonanztomographie-Vorrichtung (100) vorgesehen ist und ein Kernspintomographie-Signal empfängt, wobei die Empfangsspulenvorrichtung (200) umfasst:
eine Empfangsspule (203), die so angepasst ist, dass sie das Kernspintomographie-Signal empfängt; und
ein flexibles Band (210), das die Empfangsspule aufnimmt, eine Form aufweist, die sich als Reaktion auf Zufuhr und/oder Abgabe eines Fluids ändert, und so angepasst ist, dass es die Empfangsspule um einen Untersuchungsteil einer Untersuchungsperson (102) auf einem Untersuchungstisch der Magnetresonanztomographie-Vorrichtung (100) wickelt oder die Wicklung der Empfangsspule freigibt;
**dadurch gekennzeichnet, dass** das flexible Band
einen Teil aufweist, der so angepasst ist, dass er an dem Untersuchungstisch (130) befestigt ist,
durch Zusammenbinden einer ersten Schicht, die die Empfangsspule aufnimmt, einer zweiten Schicht, die einen zweiten taschenförmigen Strukturabschnitt (244) aufweist und so angepasst ist, dass sie durch das dem zweiten taschenförmigen Strukturabschnitt zugeführte Fluid gestreckt wird, und einer dritten Schicht, die einen dritten taschenförmigen Strukturabschnitt (246) aufweist und so angepasst ist, dass sie durch das dem dritten taschenförmigen Strukturabschnitt zugeführte Fluid gekrümmt wird, gebildet ist, und
so angepasst ist, dass es die Empfangsspule so streckt, dass es in einem Fall, in dem das Fluid aus dem dritten taschenförmigen Strukturabschnitt abgegeben wird und das Fluid dem zweiten taschenförmigen Strukturabschnitt zugeführt wird, ermöglicht,
mindestens die Wicklung der Empfangsspule um den Untersuchungsteil freizugeben, und so angepasst ist, dass es so gekrümmt wird, dass es die Empfangsspule in einem Fall, in dem das Fluid dem dritten taschenförmigen Strukturabschnitt zugeführt wird, um den Untersuchungsteil wickelt.

2. Empfangsspulenvorrichtung nach Anspruch 1,
wobei sich bei dem flexiblen Band (210) die erste Schicht, die zweite Schicht und die dritte Schicht so überlappen, dass sie in dieser Reihenfolge von einer innersten Umfangsseite des flexiblen Bands zusammengebunden werden, oder sich die zweite Schicht, die erste Schicht und die dritte Schicht so überlappen, dass sie in dieser Reihenfolge von der innersten Umfangsseite des flexiblen Bands zusammengebunden werden.

3. Empfangsspulenvorrichtung nach Anspruch 1 oder 2,
wobei die erste Schicht auf einer innersten Umfangsseite des flexiblen Bands (210) angeordnet ist, das gekrümmt ist, und die zweite Schicht und die dritte Schicht in Bezug auf die erste Schicht auf einer Außenumfangsseite angeordnet sind.

4. Empfangsspulenvorrichtung nach einem der Ansprüche 1 bis 3,
wobei die erste Schicht einen ersten taschenförmigen Strukturabschnitt (242) enthält, der die Empfangsspule (203) aufnimmt.

5. Empfangsspulenvorrichtung nach einem der Ansprüche 1 bis 4, ferner umfassend:
einen Fluiddruckkreislauf (250), der eine Fluiddruckquelle (251), die so angepasst ist, dass sie das Fluid zuführt und/oder abgibt, ein erstes Rohr (252) und ein zweites Rohr (254), die zwischen der Fluiddruckquelle und dem zweiten taschenförmigen Strukturabschnitt (244) und zwischen der Fluiddruckquelle und dem dritten taschenförmigen Strukturabschnitt (246) angeordnet sind, und ein Magnetventil (256), das bei dem ersten Rohr und dem zweiten Rohr angeordnet ist und so angepasst ist, dass es Richtungen der durch das erste Rohr und das zweite Rohr strömenden Fluide umschaltet, enthält; und
eine Steuerung (260), die so konfiguriert ist, dass sie die Fluiddruckquelle und das Magnetventil steuert,
wobei die Steuerung so konfiguriert ist, dass sie: in einem Fall, in dem eine Anweisung zum Wickeln der Empfangsspule (203) empfangen wird, die Fluiddruckquelle und das Magnetventil so steuert, dass das Fluid aus dem zweiten taschenförmigen Strukturabschnitt via das erste Rohr und das Magnetventil abgegeben wird, das Fluid von der Fluiddruckquelle via das Magnetventil und das zweite Rohr dem dritten taschenförmigen Strukturabschnitt zuführt und die Empfangsspule um den Untersuchungsteil wickelt; und in einem Fall, in dem eine Anweisung zum Freigeben der Wicklung der Empfangsspule empfangen wird, das Fluid aus dem dritten taschenförmigen Strukturabschnitt via das zweite Rohr und das Magnetventil abgibt und das Fluid von der Fluiddruckquelle via das Magnetventil und das erste Rohr dem zweiten taschenförmigen Strukturabschnitt so zuführt, dass die Wicklung der Empfangsspule um den Untersuchungsteil freigegeben wird.

6. Empfangsspulenvorrichtung nach Anspruch 5,
wobei die Steuerung (260) so konfiguriert ist, dass sie als die Anweisung zum Wickeln der Empfangsspule (203) eine Anweisung zum Anheben des Untersuchungstisches (130) oder einen ersten Zeitpunkt bei Steuerung des Anhebens des Untersuchungstisches empfängt.

7. Empfangsspulenvorrichtung nach Anspruch 5,
wobei die Steuerung (260) so konfiguriert ist, dass sie als die Anweisung zum Freigeben der Wicklung der Empfangsspule (203) eine Anweisung zum Herausziehen des Untersuchungstisches (130) aus einer Gantry (110) der Magnetresonanztomographie-Vorrichtung (100) oder einen zweiten Zeitpunkt bei Steuerung des Herausziehens des Untersuchungstisches empfängt.

8. Magnetresonanztomographie-Vorrichtung, umfassend:
die Empfangsspulenvorrichtung (200) nach einem der Ansprüche 1 bis 7.

## Revendications

1. Dispositif de bobine de réception adapté pour être prévu dans un appareil d'imagerie par résonance magnétique (100) et pour recevoir un signal de résonance magnétique nucléaire, le dispositif de bobine de réception (200) comprenant :
une bobine de réception (203) adaptée pour recevoir le signal de résonance magnétique nucléaire ; et
une bande flexible (210) qui loge la bobine de réception, a une forme qui change en réponse à l'alimentation et/ou à l'évacuation d'un fluide, et est adaptée pour enrouler la bobine de réception autour d'une partie d'examen d'un sujet (102) sur une table d'examen de l'appareil d'imagerie par résonance magnétique (100) ou pour libérer l'enroulement de la bobine de réception ;
**caractérisé en ce que** la bande flexible
comporte une partie adaptée pour être fixée à la table d'examen (130),
est formée en liant ensemble une première couche qui loge la bobine de réception, une deuxième couche qui comporte une deuxième partie structurelle en forme de sac (244) et est adaptée pour être étirée par le fluide alimenté à la deuxième partie structurelle en forme de sac, et une troisième couche qui comporte une troisième partie structurelle en forme de sac (246) et est adaptée pour être courbée par le fluide alimenté à la troisième partie structurelle en forme de sac, et
est adaptée pour étirer la bobine de réception pour permettre à au moins la libération de l'enroulement de la bobine de réception autour de la partie d'examen dans un cas où le fluide est évacué de la troisième partie structurelle en forme de sac et le fluide est alimenté à la deuxième partie structurelle en forme de sac, et est adaptée pour être courbée pour enrouler la bobine de réception autour de la partie d'examen dans un cas où le fluide est alimenté à la troisième partie structurelle en forme de sac.

2. Dispositif de bobine de réception selon la revendication 1,
dans lequel, dans la bande flexible (210), la première couche, la deuxième couche et la troisième couche se chevauchent pour être liées ensemble dans cet ordre à partir d'un côté périphérique le plus interne de la bande flexible, ou la deuxième couche, la première couche et la troisième couche se chevauchent pour être liées ensemble dans cet ordre à partir du côté périphérique le plus interne de la bande flexible.

3. Dispositif de bobine de réception selon la revendication 1 ou la revendication 2,
dans lequel la première couche est disposée sur un côté périphérique le plus interne de la bande flexible (210) qui est incurvé, et la deuxième couche et la troisième couche sont disposées sur un côté périphérique externe par rapport à la première couche.

4. Dispositif de bobine de réception selon l'une quelconque des revendications 1 à 3,
dans lequel la première couche inclut une première partie structurelle en forme de sac (242) qui loge la bobine de réception (203).

5. Dispositif de bobine de réception selon l'une quelconque des revendications 1 à 4, comprenant en outre :
un circuit de pression de fluide (250) incluant une source de pression de fluide (251) adaptée pour alimenter et/ou évacuer le fluide, un premier tube (252) et un deuxième tube (254) qui sont disposés entre la source de pression de fluide et la deuxième partie structurelle en forme de sac (244) et entre la source de pression de fluide et la troisième partie structurelle en forme de sac (246), et une électrovanne (256) qui est disposée dans le premier tube et le deuxième tube et adaptée pour commuter des directions des fluides s'écoulant à travers le premier tube et le deuxième tube ; et
un contrôleur (260) configuré pour contrôler la source de pression de fluide et l'électrovanne,
dans lequel le contrôleur est configuré pour : dans un cas où une instruction d'enroulement de la bobine de réception (203) est reçue, contrôler la source de pression de fluide et l'électrovanne pour évacuer le fluide de la deuxième partie structurelle en forme de sac via le premier tube et l'électrovanne, alimenter le fluide de la source de pression de fluide à la troisième partie structurelle en forme de sac via l'électrovanne et le deuxième tube, et enrouler la bobine de réception autour de la partie d'examen ; et dans un cas où une instruction de libération de l'enroulement de la bobine de réception est reçue, évacuer le fluide de la troisième partie structurelle en forme de sac via le deuxième tube et l'électrovanne et alimenter le fluide de la source de pression de fluide à la deuxième partie structurelle en forme de sac via l'électrovanne et le premier tube pour libérer l'enroulement de la bobine de réception autour de la partie d'examen.

6. Dispositif de bobine de réception selon la revendication 5,
dans lequel le contrôleur (260) est configuré pour, comme instruction d'enroulement de la bobine de réception (203), recevoir une instruction de levage de la table d'examen (130) ou un premier moment de contrôle de levage de la table d'examen.

7. Dispositif de bobine de réception selon la revendication 5,
dans lequel le contrôleur (260) est configuré pour, comme instruction de libération de l'enroulement de la bobine de réception (203), recevoir une instruction de sortie de la table d'examen (130) d'un portique (110) de l'appareil d'imagerie par résonance magnétique (100) ou un deuxième moment de contrôle de sortie de la table d'examen.

8. Appareil d'imagerie par résonance magnétique comprenant :
le dispositif de bobine de réception (200) selon l'une quelconque des revendications 1 à 7.
